# EUROPEAN PATENT APPLICATION

(11) **EP 4 823 251 A1**
(43) Date of publication of application: **14.10.2026**
(21) Application number: 24905609.4
(22) Date of filing: 23.08.2024
(51) Int. Cl.: H05K 5/02

(54) **CONTROLLER AND ELECTRICAL DEVICE**

(30) Priority: 22.12.2023 CN 202323534015 U; 22.12.2023 CN 202323537092 U; 22.12.2023 CN 202323534105 U
(71) Applicant: Shanghai Kong Intelligent Building Co., Ltd, Shanghai 200080 (CN); GD Kong Intelligent Building Co., Ltd., Foshan, Guangdong 528311 (CN)
(72) Inventor: CUI, Lei, Shanghai 200080 (CN); HU, Jiongpei, Shanghai 200080 (CN); CAI, Yingrong, Shanghai 200080 (CN); YAN, Jie, Shanghai 200080 (CN); LI, Bo, Shanghai 200080 (CN); WANG, Yunfang, Shanghai 200080 (CN)
(74) Representative: Ran, Handong
(86) International application number: PCT/CN2024/114240
(87) International publication number: WO 2025/130115

(57) **Abstract**

A controller and an electrical device. The controller comprises: a mounting hanging plate, the mounting hanging plate comprising a hanging plate body and lugs, the hanging plate body being provided with an opening, each lug being arranged on the inner edge of the hanging plate body and extending towards the interior of the opening, each lug being provided with a first connecting part, the hanging plate body being provided with a second connecting part, and the first connecting part and the second connecting part being selectively connected to a pre-assembled fitting; and a control module, the control module being partially inserted in the opening and being connected to the mounting hanging plate. The controller of the present utility model can be installed on components in different installation scenarios, so that the controller can be installed in a junction box, such as an 86 type box, and can also be installed on frame-type connectors, so that the controller is compatible with more application scenarios.

## Description

### CROSS-REFERENCE TO RELATED APPLICATIONS

The present application claims priority and benefits from the following patent applications, the entire disclosures of which are incorporated herein by reference:

Chinese patent application No. 202323534015.X, entitled "CONTROLLER AND ELECTRICAL DEVICE", Chinese patent application No. 202323537092.0, entitled "CONTROLLER AND ELECTRICAL DEVICE", and Chinese patent application No. 202323534105.9, entitled "CONTROLLER AND ELECTRICAL DEVICE", all of which were filed with China National Intellectual Property Administration on December 22, 2023.

### TECHNICAL FIELD

The present disclosure belongs to the technical field of home electronic products, and in particular relates to a controller and an electrical device.

### BACKGROUND

This section only provides background information related to the present disclosure, which is not necessarily the prior art.

Wired controllers or central controllers are generally used for remote terminals or smart terminals. For example, wired controllers are widely used in air conditioning systems as the wired controllers for air conditioners. An 86 box is a specification for junction boxes and is also an industry standard in electrical decoration. Therefore, the 86 box has a unified structure. The existing wired controllers or central controllers can only be fixedly installed in junction boxes such as 86 boxes, and cannot be compatible with more application scenarios.

### SUMMARY

According to a first aspect of the present utility model, a controller is proposed, which includes: an installation hanging plate, which includes a hanging plate body and an ear plate, where the hanging plate body is provided with an opening, and the ear plate is provided on an inner edge of the hanging plate body and extends toward an interior of the opening; the ear plate is provided with a first connection portion, the hanging plate body is provided with a second connection portion, and the first connection portion and the second connection portion are selectively connected to pre-assembled members; and a control module, which is partially inserted through the opening and connected to the installation hanging plate.

In the controller according to the present utility model, by providing the first connection portion and the second connection portion on the installation hanging plate respectively, which are used to connect with different pre-assembled members respectively, the controller can be installed on components in different installation scenarios, so that the controller can be installed either in junction boxes such as 86 boxes, or on frame type connectors, making the controller compatible with more application scenarios.

In addition, the controller according to the present utility model may also have the following additional technical features.

In some embodiments of the present utility model, the installation hanging plate is provided with a first error-proofing structure, and the control module is provided with a second error-proofing structure, which is adapted and connected to the first error-proofing structure.

In some embodiments of the present utility model, the first connection portion includes an assembly hole provided on the ear plate, which is used to correspond with an installation hole of the pre-assembled member which is a junction box.

In some embodiments of the present utility model, the installation hanging plate is provided with indication signs.

In some embodiments of the present utility model, the first error-proofing structure includes at least one ear plate arranged on the inner edge of the installation hanging plate, and the second error-proofing structure includes at least one assembly groove arranged at one end of the control module that faces the installation hanging plate, the contour of each assembly groove matching the contour of a unique one ear plate.

In some embodiments of the present utility model, an inner edge of the opening abuts with an outer peripheral surface of the control module; the opening includes a first inner edge and a second inner edge arranged opposite to each other in a first direction, and the ear plate is located between the first inner edge and the second inner edge; where a distance between the ear plate and the first inner edge is larger than a distance between the ear plate and the second inner edge, or the distance between the ear plate and the first inner edge is smaller than the distance between the ear plate and the second inner edge.

In some embodiments of the present utility model, the control module includes a power supply rear cover, which includes a rear casing portion and a convex edge portion that are connected to each other; the convex edge portion is provided on an outer peripheral surface of the rear casing portion and extends in a circumferential direction of the rear casing portion; the convex edge portion abuts with the installation hanging plate, and the rear casing portion is inserted into the opening; where the rear casing portion is provided with the assembly groove that matches the contour of the ear plate, and when the control module is installed on the installation hanging plate, the ear plate is arranged in the assembly groove.

In some embodiments of the present utility model, the rear casing portion is provided with at least one buckle, and the power supply rear cover is snap-fitted to the installation hanging plate through the at least one buckle.

In some embodiments of the present utility model, the buckle includes a cantilever portion suspended at one end and a protruding portion provided at a free end of the cantilever portion; the protruding portion is spaced apart from the convex edge portion, and the installation hanging plate is clamped between the protruding portion and the convex edge portion.

In some embodiments of the present utility model, in an insertion direction of the buckle, one end of the protruding portion that faces away from the convex edge portion is configured as a first guide surface inclined relative to the installation hanging plate; and/or in the insertion direction of the buckle, one end of the protruding portion that faces the convex edge portion is configured as a second guide surface inclined relative to the installation hanging plate.

In some embodiments of the present utility model, an outer edge of the installation hanging plate is provided with a disassembly and assembly guide buckle, and a guide groove is provided on an end face of one side of the control module that faces the installation hanging plate; the disassembly and assembly guide buckle is inserted into the guide groove, and the guide groove forms a disassembly port at the edge of the control module.

In some embodiments of the present utility model, the second connection portion includes at least one connection hole provided on the hanging plate body, which is used for a connector to pass through, so that the installation hanging plate is connected with the pre-assembled member in the form of a frame.

In some embodiments of the present utility model, the convex edge portion is provided with multiple avoidance grooves, which are arranged in a one-to-one correspondence with the connection holes.

In some embodiments of the present utility model, the control module further includes an upper cover connected to the power supply rear cover, and a first installation groove is provided on one side of the power supply rear cover that faces away from the upper cover; the installation hanging plate is at least partially accommodated in the first installation groove, and is connected to the power supply rear cover.

In some embodiments of the present utility model, the power supply rear cover is partially recessed on one side facing the upper cover to form a receiving groove, and the control module further includes a power board, which is arranged in the receiving groove.

In some embodiments of the present utility model, one of inner wall surfaces of the power board and the receiving groove is provided with a limiting protrusion, and the other is provided with a limiting groove, the limiting protrusion being inserted into the limiting groove; and/or the inner wall surface of the receiving groove is provided with a first connection structure, which is connected to the power board.

In some embodiments of the present utility model, a second installation groove is provided on one side of the upper cover that faces the power supply rear cover, and the controller further includes a main control board, which is arranged in the second installation groove and connected to the upper cover and/or the power supply rear cover; and/or one of the convex edge portion and the upper cover is provided with a first snap-fit protrusion, the other is provided with a snap-fit groove, and the upper cover and the power supply rear cover are snap-fitted to the snap-fit groove through the first snap-fit protrusion.

In some embodiments of the present utility model, an inner sidewall of the second installation groove is provided with a second connection structure, which is connected to the main control board.

In some embodiments of the present utility model, the control module further includes an electronic paper display assembly, which is arranged on one side of the upper cover that faces away from the power supply rear cover.

In some embodiments of the present utility model, the electronic paper display assembly has a first installation hole, the control module further includes a knob assembly and a light guide assembly, and part of the light guide assembly is provided in the first installation hole; the light guide assembly has a second installation hole, the upper cover has a third installation hole, and part of the knob assembly is rotatably installed in the second installation hole and the third installation hole.

According to a second aspect of the present utility model, an electrical device is also proposed, which includes a control system and the controller as described in the technical solution of the first aspect, where the controller is electrically connected to the control system.

### BRIEF DESCRIPTION OF THE DRAWINGS

Upon reading detailed description of the preferred embodiments below, various other advantages and benefits will become clear to those skilled in the art. The accompanying drawings are only used for the purpose of illustrating the preferred embodiments, and should not be considered as a limitation to the present utility model. Moreover, throughout the drawings, the same reference signs are used to denote the same components. In the drawings:
FIG. 1 is a schematic structural view of a controller and a junction box according to an embodiment of the present utility model;
FIG. 2 is a schematic structural view of the controller and a pre-assembled member according to an embodiment of the present utility model;
FIG. 3 is a schematic structural view of an installation hanging plate according to an embodiment of the present utility model;
FIG. 4 is a schematic structural view of a control module according to an embodiment of the present utility model;
FIG. 5 is a schematic structural view of the controller according to an embodiment of the present utility model;
FIG. 6 is a schematic structural view of a power supply rear cover according to an embodiment of the present utility model;
FIG. 7 is a partially enlarged schematic view of part A in FIG. 6;
FIG. 8 schematically shows a schematic structural view of the controller according to an embodiment of the present utility model from a first perspective;
FIG. 9 schematically shows a schematic structural view of the controller according to an embodiment of the present utility model from the first perspective (the installation hanging plate not shown);
FIG. 10 schematically shows a schematic structural view of the installation hanging plate according to an embodiment of the present utility model;
FIG. 11 schematically shows a schematic structural view of the power supply rear cover according to an embodiment of the present utility model;
FIG. 12 schematically shows a schematic exploded structural view of the controller according to an embodiment of the present utility model;
FIG. 13 schematically shows a schematic structural view of a second shell of the controller according to an embodiment of the present utility model;
FIG. 14 schematically shows a schematic structural view of the controller according to an embodiment of the present utility model from a second perspective;
FIG. 15 schematically shows a schematic structural view of a knob assembly according to an embodiment of the present utility model; and
FIG. 16 schematically shows a schematic structural view of a light guide assembly according to an embodiment of the present utility model.

### List of reference signs:

100: controller;
10: installation hanging plate; 11: hanging plate body; 111: opening; 1111: first inner edge; 1112: second inner edge; 112: symmetrical line; 12: first error-proofing structure; 121: ear plate; 122: disassembly and assembly guide buckle; 13: first connection portion; 131: assembly hole; 14: second connection portion; 141: connection hole; 101: bottom; 102: top; 103: indication sign; 1010: first plate body; 1020: second plate body; 115: first installation groove; 116: limiting column;
20: control module; 21: power supply rear cover; 211: rear casing portion; 212: convex edge portion; 2101: receiving groove; 2121: avoidance groove; 213: buckle; 2131: cantilever portion; 2132: protruding portion; 21321: first guide surface; 21322: second guide surface; 214: second error-proofing structure; 2141: assembly groove; 2142: guide groove;
22: upper cover; 201: first side; 202: second side; 2241: second installation groove; 2242: third installation hole;
30: power board; 301: limiting protrusion; 31: main control board; 311: first snap-fit protrusion;
50: electronic paper display assembly; 51: first installation hole;
60: knob assembly; 61: third buckle;
70: light guide assembly; 71: fourth buckle; 72: second installation hole;
200: junction box; 2001: installation hole; 300: pre-assembled member;

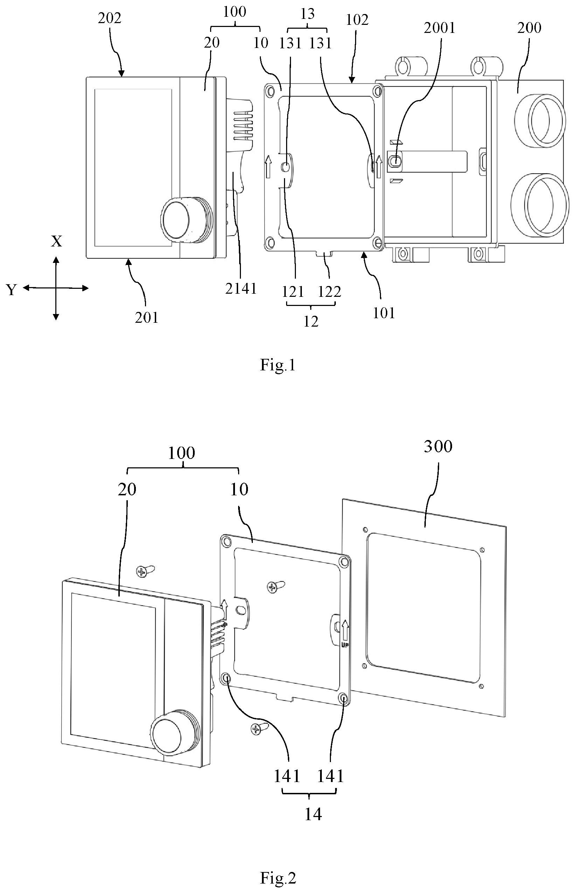

In FIG. 1: X represents a first direction and Y represents a second direction.

### DETAILED DESCRIPTION

Hereinafter, exemplary embodiments of the present utility model will be described in greater detail with reference to the accompanying drawings. Although the exemplary embodiments of the present utility model are shown in the drawings, it should be understood that the present application may be implemented in various forms and should not be limited by the embodiments set forth herein. On the contrary, these embodiments are provided to enable a more thorough understanding of the present utility model and to fully convey the scope of the present utility model to those skilled in the art.

It should be understood that the terms used herein are only for the purpose of describing specific exemplary embodiments, and are not intended to be limitative. Unless clearly indicated otherwise in the context, singular forms "a", "an", and "said" as used herein may also mean that plural forms are included. Terms "include", "comprise", "contain" and "have" are inclusive, and therefore indicate the existence of the stated features, steps, operations, elements and/or components, but do not exclude the existence or addition of one or more other features, steps, operations, elements, components, and/or combinations thereof. The method steps, processes, and operations described herein should not be interpreted as requiring them to be executed in the specific order described or illustrated, unless the order of execution is clearly indicated. It should also be understood that additional or alternative steps may be used.

Although terms "first", "second", "third" and the like may be used herein to describe multiple elements, components, regions, layers and/or sections, these elements, components, regions, layers and/or sections should not be limited by these terms. These terms may be only used to distinguish one element, component, region, layer or section from another region, layer or section. Unless clearly indicated in the context, terms such as "first", "second" and other numerical terms do not imply an order or sequence when they are used herein. Therefore, the first element, component, region, layer or section discussed below may be referred to as a second element, component, region, layer or section without departing from the teachings of the exemplary embodiments.

For ease of description, spatial relative terms may be used herein to describe the relationship of one element or feature relative to another element or feature as shown in the drawings. These relative terms are, for example, "inner", "outer", "inside", "outside", "below", "under", "above", "over", etc. These spatial relative terms are intended to include different orientations of the device in use or in operation in addition to the orientation depicted in the drawings. For example, if the device in the figure is rotated, then elements described as "below other elements or features" or "under other elements or features" will then be oriented "above the other elements or features" or "over the other elements or features". Thus, the exemplary term "below" may include orientations of both above and below.

As shown in FIG. 1 and FIG. 2, in some embodiments of the present utility model, a controller 100 includes an installation hanging plate 10 and a control module 20. The control module 20 has electronic components for transmitting control signals to an air conditioner, such as control buttons, control knobs, and display screens. The control module 20 is installed onto a junction box 200 or a pre-assembled member 300 such as cabinet and wall through the installation hanging plate 10.

In the present utility model, the controller includes but is not limited to a wired controller or a central controller.

In this embodiment, as shown in FIGS. 1, 4 and 5, the installation hanging plate 10 has a bottom 101 and a top 102 arranged opposite to each other. Generally, when installing the installation hanging plate 10 onto the junction box 200, in a case where the junction box 200 is placed on the wall, the top 102 is oriented facing upward and the bottom 101 is oriented facing downward. It can be understood that in other installation scenarios, if the junction box 200 is horizontally placed, the top 102 faces away from the operator's side and the bottom 101 faces the operator's side.

Further, the control module 20 has a first side 201 and a second side 202 arranged opposite to each other. The installation hanging plate 10 is provided with a first error-proofing structure 12, and the control module 20 is provided with a second error-proofing structure 214 adapted to the first error-proofing structure 12. The first error-proofing structure 12 is adapted to the second error-proofing structure 214. When the control module 20 is installed onto the installation hanging plate 10, the first error-proofing structure 12 is connected to the second error-proofing structure 214. In this embodiment, the cooperation between the first error-proofing structure 12 and the second error-proofing structure 214 can define the installation of the control module 20 onto the installation hanging plate 10 in a positive direction, preventing inverted installation of the control module 20. Specifically, the positive direction refers to the direction in which the first side 201 is opposite to the bottom 101 and the second side 202 is opposite to the top 102.

It can be understood that if the installation direction of the control module 20 is inverted, the first error-proofing structure and the second error-proofing structure 214 cannot be adapted to each other, so that the control module 20 cannot be installed onto the installation hanging plate 10 in the inverted direction.

In some embodiments, the installation hanging plate 10 includes a hanging plate body 11 and an ear plate 121 connected to the hanging plate body 11. The hanging plate body 11 is in a frame shape and defines an opening 111. The ear plate 121 is provided on an inner edge of the hanging plate body 11 and extends toward an interior of the opening 111. The first error-proofing structure 12 includes the ear plate 121, and the second error-proofing structure 214 includes an assembly groove 2141 formed on the control module 20. The assembly groove 2141 is provided at one end of the control module 20 that faces the installation hanging plate 10. The contour of the assembly groove 2141 matches the ear plate 121, and the contour of each assembly groove 2141 matches the contour of a unique one ear plate 121 to achieve the error-proofing effect during the connection process between the control module 20 and the installation hanging plate 10.

In some specific examples, the specific shapes of the ear plate 121 and the assembly groove 2141 can be optimized to have a unique alignment relationship between the two, thereby defining the installation direction of the control module 20 and the installation hanging plate 10. For example, in a case where there is one ear plate 121 and one assembly groove 2141, the contour of the ear plate 121 is asymmetric, and the contour of the assembly groove 2141 matches the contour of the ear plate 121. Therefore, the control module 20 can only be installed onto the installation hanging plate 10 in the positive direction. In case of inverted installation, since the ear plate 121 does not match the assembly groove 2141, it is impossible for the control module 20 to be installed onto the installation hanging plate 10 in the inverted direction. For example, when each of the numbers of ear plates 121 and assembly grooves 2141 is two or more, the contour shapes of each ear plate 121 are different. For example, when the number of ear plates 121 is two, one ear plate 121 is set to be rectangular and the other ear plate 121 is set to be elliptical. Among the two assembly grooves 2141, the contour of one assembly groove 2141 matches the rectangular ear plate 121, and the contour of the other assembly groove 2141 matches the elliptical ear plate 121. Therefore, the control module 20 and the installation hanging plate 10 have a uniquely determined installation method to prevent inverted installation.

In some other specific embodiments, by optimizing the placement position of the ear plate 121 on the installation hanging plate 10, the control module 20 can have a unique alignment relationship with the installation hanging plate 10, thereby defining the installation direction of the control module 20 and the installation hanging plate 10. The feasible implementation is as follows.

In this embodiment, as shown in FIGS. 1, 3 and 5, when the control module 20 is installed onto the installation hanging plate 10, the control module 20 is inserted through the opening 111 and a circumferential outer contour of the control module 20 abuts with the inner edge of the opening 111. The ear plate 121 is arranged in the assembly groove 2141, and a circumferential outer contour of the ear plate 121 matches an inner wall of the assembly groove 2141, thereby limiting the position between the control module and the installation hanging plate 10.

Further, in a first direction, the opening 111 has a first inner edge 1111 and a second inner edge 1112 arranged opposite to each other in the first direction. The opening 111 has a symmetrical line 112 that bisects the opening 111 itself. A distance between the ear plate 121 and the first inner edge 1111 is larger than a distance between the ear plate 121 and the second inner edge 1112, or the distance between the ear plate 121 and the first inner edge 1111 is smaller than the distance between the ear plate 121 and the second inner edge 1112, causing the ear plate 121 to deviate from the symmetrical line 112. Since the ear plate 121 deviates from the symmetrical line 112 and the circumferential outer contour of the control module 20 abuts with the inner edge of the opening 111, when the control module 20 is installed onto the installation hanging plate 10 in the first direction, the ear plate 121 is aligned with the assembly groove 2141 and can enter the assembly groove 2141. However, when the control module 20 is installed onto the installation hanging plate 10 in the inverted direction, based on the limiting effect of the circumferential outer contour of the control module 20 and the inner edge of the opening 111, the assembly groove 2141 is misaligned with the ear plate 121, and the ear plate 121 interferes with the control module 20, making it impossible for the control module 20 to penetrate into the opening 111 and move to the assembly position of the control module 20 and the installation hanging plate 10.

Bisecting the opening 111 by the symmetrical line 112 means that a distance from the symmetrical line 112 to the first inner edge 1111 is equal to a distance from the symmetrical line 112 to the second inner edge 1112.

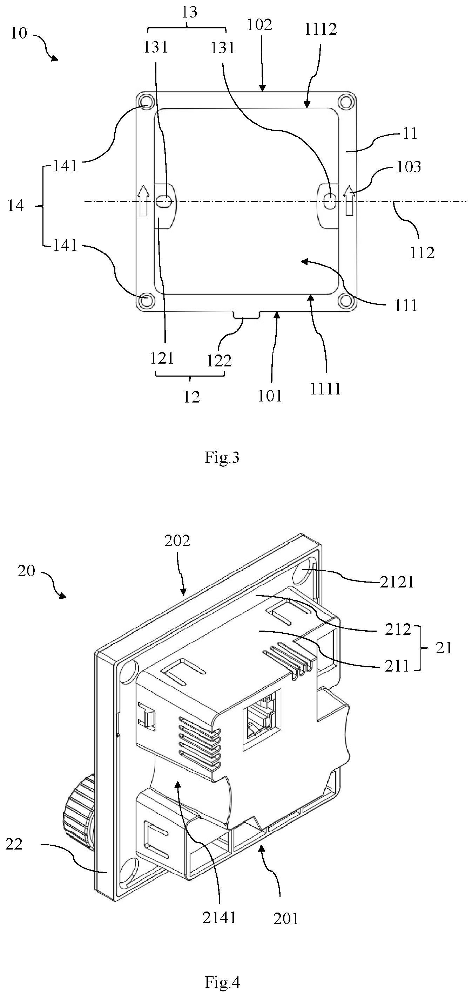

In some embodiments of the present utility model, as shown in FIG. 3, the first error-proofing structure 12 includes two ear plates 121, which are respectively arranged on the two inner edges of the hanging plate body 11 that are opposite to each other in a second direction, where the second direction is perpendicular to the first direction. Both ear plates 121 deviate toward the same side of the symmetrical line 112 relative to the symmetrical line 112.

In some embodiments of the present utility model, as shown in FIGS. 1, 2 and 3, the ear plate 121 is provided with a first connection portion 13, and the hanging plate body 11 is provided with a second connection portion 14. The first connection portion 13 and the second connection portion 14 are selectively connected to pre-assembled members, and the pre-assembled member 300 can be set as a frame shaped plate-like member. The first connection portion 13 can be used to connect with the junction box 200, and the second connection portion 14 can be used to connect with the frame shaped pre-assembled member 300. At least part of the control module 20 can be inserted through the connector or into the junction box 200 via the opening 111. By setting the first connection portion 13 and the second connection portion 14 respectively on the ear plate 121 and the hanging plate body 11, the controller 100 proposed in the present utility model can be installed on components in different installation scenarios. The controller 100 can be installed either in the junction box 200 such as the 86 box, or on frame shaped connectors, making the controller 10 compatible with more application scenarios.

The frame shaped pre-assembled member 300 can be a cabinet door of a control cabinet, or a wall or furniture with a square accommodating space and an opening for the controller 100 to be inserted through.

Further, the first connection portion 13 includes assembly holes 131 provided on the ear plates 121, and the assembly holes 131 are used to correspond with installation holes 2001 in the junction box 200. A value range of hole spacing between the two assembly holes 131 is 58mm to 62mm. For example, the hole spacing between the two assembly holes 131 can be set to one of 58mm, 59mm, 59.5mm, 60mm, 60.5mm, 61mm, or 62mm to facilitate compatibility with the two installation holes 2001 in the junction box 200.

In this embodiment, as shown in FIG. 3, both the opening 111 and the ear plate 121 have axisymmetric shapes. The assembly hole 131 is set as a waist-shaped hole, and the shape of the assembly hole 131 corresponds to the shape of the installation hole 2001 in the junction box 200. The ear plate 121 is an arc-shaped portion, having a plate shape and a symmetrical axis. A central axis of the assembly hole 131 coincides with the symmetrical line 112 of the opening 111, and the central axis of the assembly hole 131 is spaced apart from the symmetrical axis of the ear plate 121.

The second connection portion 14 includes at least one connection hole 141 provided in the hanging plate body 11. The installation hanging plate 10 can be connected to the cabinet door by passing a connector such as a bolt through the connection hole 141, or connected to the wall by passing a connector such as an expansion screw through the connection hole 141.

In some embodiments, as shown in FIGS. 2 and 3, the second connection portion 14 includes four connection holes 141, which are respectively located at the four corner positions of the hanging plate body 11. The installation hanging plate 10 can be connected to the cabinet door through four connectors, thereby improving the connection strength between the installation hanging plate 10 and the pre-assembled member 300 such as the cabinet door.

In some embodiments of the present utility model, as shown in FIGS. 1, 2 and 3, the installation hanging plate 10 is provided with indication signs 103, which are set in the first direction and point to the top 102. The indication signs 103 are used to provide direction indication for the installation personnel, so as to facilitate the installation personnel to correctly install the installation hanging plate 10 onto the junction box 200 or the frame shaped pre-assembled member 300 such as the cabinet door, and prevent the installation hanging plate 10 from being installed invertedly. In this embodiment, the indication signs 103 include a combination of one or more of arrows, text, and letters.

In this embodiment, as shown in FIGS. 4, 5 and 6, the control module 20 includes a power supply rear cover 21 and an upper cover 22. The power supply rear cover 21 includes a rear casing portion 211 and a convex edge portion 212 that are connected to each other. The rear casing portion 211 is hollow box shaped and forms an opening on one side. The convex edge portion 212 is provided on an outer peripheral surface of the rear casing portion 211 and surrounds the outer peripheral surface of the rear casing portion 211. The convex edge portion 212 is annular as a whole, arranged around the opening of the rear casing portion 211, and extends away from the opening of the rear casing portion 211 in the circumferential direction of the rear casing portion 211. When the rear casing portion 211 is inserted into the opening 111, the convex edge portion 212 abuts with the hanging plate body 11 of the installation hanging plate 10. The upper cover 22 and the power supply rear cover 21 are connected and cover the opening of the rear casing portion 211 to define a space between the upper cover 22 and the power supply rear cover 21 for accommodating electronic components of the control module 20.

In this embodiment, the assembly groove 2141 is formed on the outer peripheral surface of the rear casing portion 211. When the rear casing portion 211 is inserted into the opening 111, the circumferential outer contour of the rear casing portion 211 abuts with the inner edge of the opening 111, and the ear plate 121 can enter the assembly groove 2141.

In some embodiments of the present utility model, as shown in FIGS. 2 and 4, the convex edge portion 212 is provided with multiple avoidance grooves 2121, which are arranged in a one-to-one correspondence with the connection holes 141. After the installation hanging plate 10 is fixed on the cabinet door through countersunk screws, the control module 20 is installed onto the installation hanging plate 10. The avoidance grooves 2121 are used to provide installation space for the countersunk screws and avoid interference between the countersunk screws and the power supply rear cover 21.

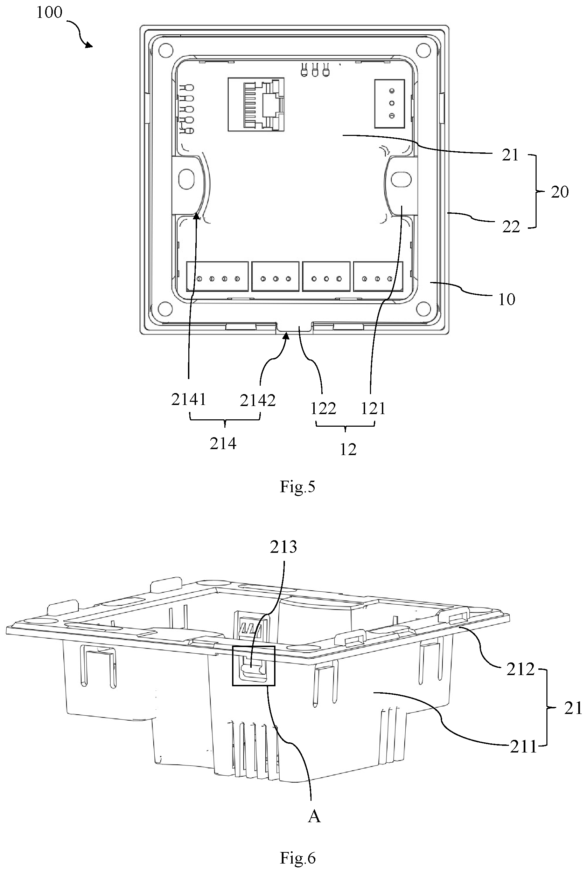

In some embodiments of the present utility model, as shown in FIGS. 4 and 6, the rear casing portion 211 is also provided with at least one buckle 213. The power supply rear cover 21 is snap-fitted to the installation hanging plate 10 through the buckle 213, so that when the installation hanging plate 10 is installed on the junction box 200 or cabinet door, the control module 20 can be quickly installed onto the installation hanging plate 10, which is advantageous for the rapid disassembly of the control module 20, thus shortening the maintenance time during later maintenance work, and reducing maintenance costs.

In some embodiments, multiple buckles 213 can be provided and spaced apart in sequence in the circumferential direction of the rear casing portion 211, thereby improving the snap-fit strength between the power supply rear cover 21 and the installation hanging plate 10, and enhancing the stability of the controller 100 after installation.

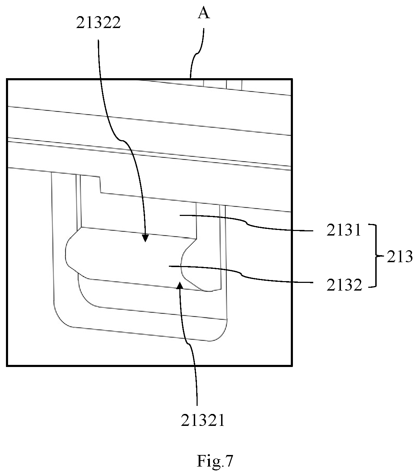

In some embodiments, as shown in FIGS. 1, 6 and 7, the buckle 213 includes a cantilever portion 2131 and a protruding portion 2132. The cantilever portion 2131 has a long strip shape, and one end of the cantilever portion 2131 is suspended in a cantilever shape. The protruding portion 2132 is located at the free end of the cantilever portion 2131, and is spaced apart from the convex edge portion 212. During the process of inserting the power supply rear cover 21 into the opening 111 and connecting it to the installation hanging plate 10, along an insertion direction of the power supply rear cover 21, the protruding portion 2132 moves from one side of the installation hanging plate 10 to the other side and clamps the installation hanging plate 10 between the protruding portion 2132 and the convex edge portion 212 by cooperating with the convex edge portion 212, so that the power supply rear cover 21 is snap-fitted with the installation hanging plate 10. The purpose of setting the cantilever portion 2131 in a cantilever shape is that when the protruding portion 2132 moves from one side of the installation hanging plate 10 to the other side, the cantilever portion 2131 can bend when pressed by the installation hanging plate 10, so that the protruding portion 2132 can avoid the installation hanging plate 10, and when the installation hanging plate 10 is located between the protruding portion 2132 and the convex edge portion 212, the cantilever portion 2131 recovers elastically, so that the protruding portion 2132 can form a limiting fit with an end face of one side of the installation hanging plate 10 away from the convex edge portion 212, thereby achieving the snap-fit connection between the installation hanging plate 10 and the power supply rear cover 21.

In this embodiment, the extension direction of the cantilever portion 2131 is parallel to the insertion direction of the power supply rear cover 21.

In some embodiments, as shown in FIGS. 1, 6 and 7, along the insertion direction of the buckle 213, one end of the protruding portion 2132 that faces away from the convex edge portion 212 is configured as a first guide surface 21321 inclined relative to the installation hanging plate 10. During the process of installing the power supply rear cover 21 onto the installation hanging plate 10, the installation hanging plate 10 first abuts with the first guide surface 21321 of the buckle 213, and under the guidance of the first guide surface 21321, the pressure acting on the first guide surface 21321 by the installation hanging plate 10 has a component force perpendicular to the cantilever portion 2131. This component force can drive the cantilever portion 2131 to bend, so that the protruding portion 2132 can avoid the installation hanging plate 10, ensuring that the power supply rear cover 21 can be smoothly snap-fitted to the installation hanging plate 10.

In some embodiments, as shown in FIGS. 1, 6 and 7, along the insertion direction of the buckle 213, one end of the protruding portion 2132 that faces the convex edge portion 212 is configured as a second guide surface 21322 inclined relative to the installation hanging plate 10. During the process of disassembling the power supply rear cover 21 from the installation hanging plate 10, the installation hanging plate 10 first abuts with the second guide surface 21322 of the buckle 213, and under the guidance of the second guide surface 21322, the pressure acting on the second guide surface 21322 by the installation hanging plate 10 has a component force perpendicular to the cantilever portion 2131. This component force can drive the cantilever portion 2131 to bend, so that the protruding portion 2132 can avoid the installation hanging plate 10, ensuring that the power supply rear cover 21 can be smoothly disassembled from the installation hanging plate 10.

In some embodiments of the present utility model, as shown in FIGS. 3 and 5, an outer edge of the bottom of the installation hanging plate 10 is provided with a disassembly and assembly guide buckle 122, and a guide groove 2142 is provided on an end face of one side of the control module 20 that faces the installation hanging plate 10. The disassembly and assembly guide buckle 122 is inserted into the guide groove 2142. In this embodiment, by providing the disassembly and assembly guide buckle 122 and utilizing the cooperation between the disassembly and assembly guide buckle 122 and the guide groove 2142 provided in the control module 20, the control module 20 and the installation hanging plate 10 have a unique assembly direction, thus also preventing the control module 20 from being invertedly installed onto the installation hanging plate 10.

Further, one end of the disassembly and assembly guide buckle 122 that is away from the hanging plate body 11 extends toward the side facing away from the opening 111. The extension direction of the guide groove 2142 is the same as that of the disassembly and assembly guide buckle 122. Along the extension direction of the guide groove 2142, the guide groove 2142 sequentially runs through the power supply rear cover 21 and the upper cover 22, and forms a disassembly and assembly port at the edge of the upper cover 22. When the control module 20 is snap-fitted with the installation hanging plate 10, the disassembly and assembly guide buckle 122 is inserted into the guide groove 2142. When it is necessary to disassemble the control module 20 from the installation hanging plate 10, a screwdriver can be inserted into the guide groove 2142 through the disassembly and assembly port and inserted between the disassembly and assembly guide buckle 122 and the convex edge portion 212. The disassembly and assembly guide buckle 122 can be pried by the screwdriver to easily disassemble the control module 20 from the installation hanging plate 10, so as to separate the control module 20 from the installation hanging plate 10.

It should be noted that the existing controllers 100 or central controllers are generally fixed in the 86 boxes. As junction boxes with industry standard specification in electrical decoration, the 86 boxes have a unified structure and are provided with two symmetrically arranged installation holes 2001.

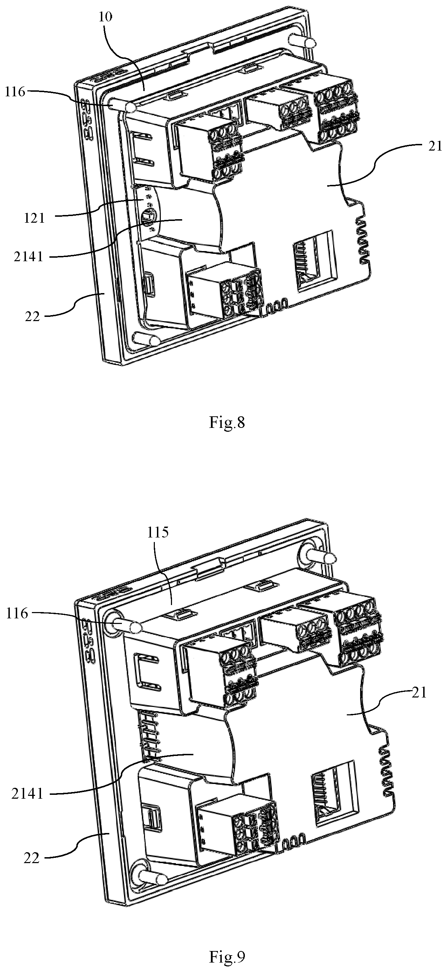

In some embodiments of the present utility model, as shown in FIGS. 8 and 9, one side of the power supply rear cover that is away from the upper cover is provided with a first installation groove 115. The installation hanging plate 10 is installed in the first installation groove 115, and is used to install a shell assembly onto the wall or door.

It can be understood that the shell assembly can be a cubic structure; it is formed by combining two half shells, and is internally formed with a cavity for placing electrical components. A first end of the shell assembly can be embedded and installed in a groove hole of the wall or door, reducing the overall thickness protruding out of the wall. A second end of the shell assembly is generally used to place user interaction assemblies to achieve interaction functions between users. The first installation groove 115 is arranged between the two ends of the shell assembly, and it can be annular or strip-shaped. The first installation groove 115 has an opening facing the wall or door. The installation hanging plate 10 is detachably arranged in the first installation groove 115, and the installation hanging plate 10 matches the shape of the first installation groove 115. The installation hanging plate 10 can be fixed to the shell assembly by snap-fit or bolts. Bolt holes can be provided on the installation hanging plate 10 for bolts to pass through, thus fixing the installation hanging plate 10 on the wall or door.

In the controller proposed by the present utility model, the first installation groove 115 is arranged between the two opposite ends of the shell assembly, and the installation hanging plate 10 is arranged in the first installation groove 115. The installation hanging plate 10 is embedded in the first installation groove 115, and a first end of the controller is embedded in the wall or door. The installation hanging plate 10 is fixedly connected to the wall or door, and the embedded arrangement of the installation hanging plate 10 ensures that the installation hanging plate 10 does not increase the overall thickness of the controller. In cooperation with the structure of partially embedding the controller into the wall or door, the controller protrudes by a small amount when installed on the wall or door, which is more beautiful, coordinated, and advantageous for cleaning.

As shown in FIGS. 8 to 11, one side of the power supply rear cover 21 that faces the upper cover 22 is partially recessed to form a receiving groove 2101. The installation hanging plate 10 is provided with an opening, and the power supply rear cover 21 is inserted through the opening and installed in an installation space of the wall or door.

It can be understood that the power supply rear cover 21 can be a basin shaped structure, such as a basin shaped structure having a rectangular cross section. One side of the power supply rear cover 21 that faces the upper cover 22 is partially recessed to define the receiving groove 2101. A first buckle is arranged in the receiving groove 2101, and a power board 30 is provided with a first fitting portion that is fitted and connected to the first buckle, so that the power board 30 can be fixed inside the receiving groove 2101 through snap-fit connection. The installation hanging plate 10 can be an annular plate structure, with an opening provided on the installation hanging plate 10. The power supply rear cover 21 is inserted through the installation hanging plate 10, so that the installation hanging plate 10 is arranged around the power supply rear cover 21 to provide good connection reliability.

It can be understood that the installation hanging plate 10 includes a first plate body 1010 and a second plate body 1020. The first plate body 1010 has an annular structure and is arranged parallel to the bottom of the first installation groove 115, so that the first plate body 1010 can be embedded and installed in the first installation groove 115. The second plate body 1020 is arranged along an inner edge of the first plate body 1010 and has an annular structure. The second plate body 1020 is arranged perpendicular to the first plate body 1010. The second plate body 1020 can be sleeved on an outer peripheral side of a side wall of the power supply rear cover 21, making the connection between the connection portion and the power supply rear cover 21 more reliable. The ear plate 121 extends from the second plate body 1020, and an assembly groove 2141 is also provided on an outer wall surface of the receiving groove 2101. The installation hanging plate 10 is installed in the first installation groove 115. The ear plate 121 is located in the assembly groove 2141. By setting the ear plate 121, the installation hanging plate 10 can be connected to the junction box or door through the ear plate 121, further enhancing the reliability of the connection between the controller and the junction box or door.

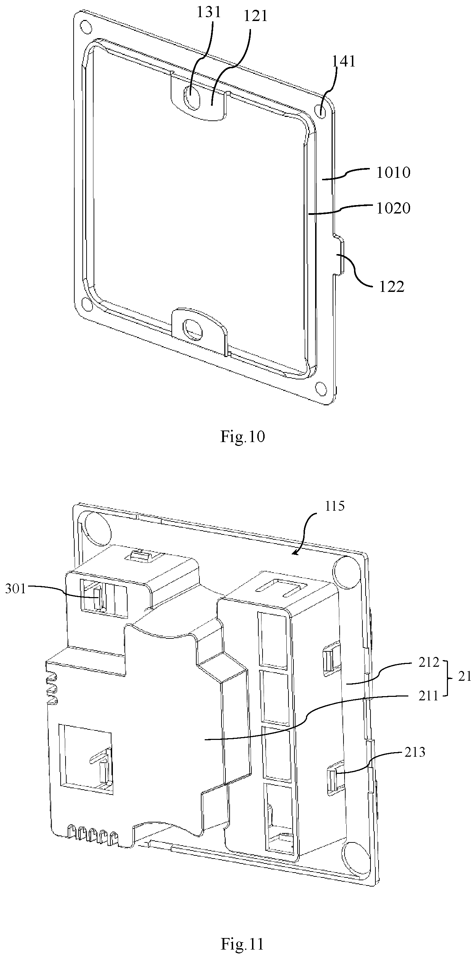

As shown in FIGS. 10 to 12, in some embodiments of the present utility model, the ear plates 121 are provided with assembly holes 131, which are used for first fasteners to pass through, so as to install the installation hanging plate 10 and the shell assembly onto the wall;
or the installation hanging plate 10 is provided with connection holes 141, which are used for second fasteners to pass through, so as to install the installation hanging plate 10 and the shell assembly onto the wall.

It can be understood that the ear plates 121 are provided with assembly holes 131. When installing the installation hanging plate 10, bolts can be fixed to the wall or door through the assembly holes 131, and then the installation hanging plate 10 can be embedded and installed in the first installation groove 115. More specifically, limiting portions can be provided in the first installation groove 115; for example, limiting columns 116 match with the connection holes 141 on the installation hanging plate 10 to achieve the connection between the power supply rear cover 21 and the installation hanging plate 10 and to limit the installation hanging plate 10, thereby improving the reliability of the connection between the power supply rear cover 21 and the installation hanging plate 10. The limiting columns 116 can also connect the power supply rear cover 21 with the junction box or door, further improving the reliability of installing the controller. Further, when the first installation groove 115 and the installation hanging plate 10 are in a "□" shape, the connection holes 141 can be arranged at the four corners of the installation hanging plate 10, and the corresponding limiting columns 116 can be arranged at the four corners of the first installation groove 115.

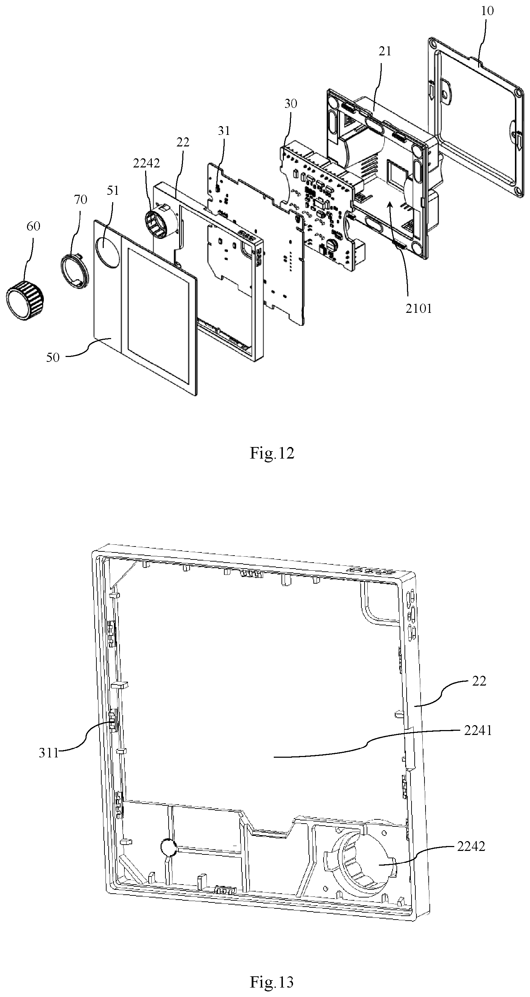

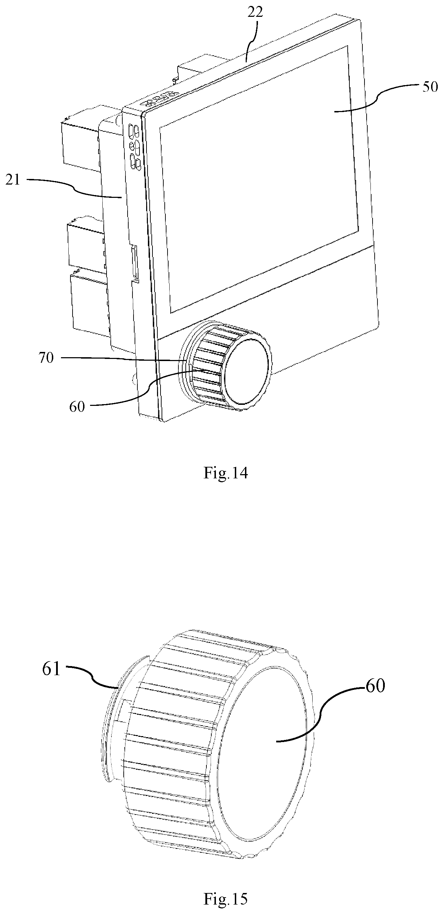

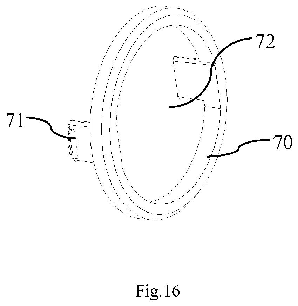

As shown in FIGS. 12 to 16, in some embodiments of the present utility model, the controller further includes a power board 30, which is arranged in the receiving groove 2101.

It can be understood that the power board 30 can be fixed to the power supply rear cover 21 through a buckle or limiting structure, which makes the installation convenient and achieves strong connection reliability.

As shown in FIGS. 11 to 12, in some embodiments of the present utility model, one of the inner wall surfaces of the power board 30 and the receiving groove 2101 is provided with a limiting protrusion 301, and the other is provided with a limiting groove. The limiting protrusion 301 is inserted into the limiting groove;
and/or the inner wall surface of the receiving groove 2101 is provided with a first connection structure, which is connected to the power board 30.

It can be understood that the limiting protrusion 301 is arranged inside the receiving groove 2101, and the limiting groove matched and connected with the limiting protrusion 301 is arranged on the power board 30, so that the power board 30 can be fixed inside the receiving groove 2101 through snap-fit connection. The inner wall surface of the receiving groove 2101 can also be provided with a first connection structure, which can be in the structural form of a buckle. The first connection structure can be connected to the power board 30 through the buckle so that the power board 30 is accommodated in the receiving groove 2101, reducing the overall thickness of the controller and improving aesthetic level.

As shown in FIGS. 12 to 13, in some embodiments of the present utility model, a second installation groove 2241 is provided on one side of the upper cover 22 that faces the power supply rear cover 21. The controller also includes a main control board 31, which is arranged in the second installation groove 2241 and connected to the upper cover 22 and/or the power supply rear cover 21;
and/or the peripheral side of the power supply rear cover 21 is folded in a direction away from the receiving groove 2101 to form the convex edge portion 212; one of the convex edge portion 212 and the upper cover 22 is provided with a first snap-fit protrusion 311, and the other is provided with a snap-fit groove; the upper cover 22 and the power supply rear cover 21 are connected to the snap-fit groove through the first snap-fit protrusion 311.

It can be understood that a second installation groove 2241 is formed on the upper cover 22, and the second installation groove 2241 is adapted to one side of the power supply rear cover 21 on which the convex edge portion 212 is provided. A buckle or limiting structure can be provided in the second installation groove 2241 to fix the main control board 31. By providing the second installation groove 2241 on the upper cover 22 to accommodate the main control board 31, the main control board 31 is protected and the fixing reliability of the main control board 31 is improved.

As shown in FIGS. 12 to 13, in some embodiments of the present utility model, an inner sidewall of the second installation groove 2241 is provided with a second connection structure, which is connected to the main control board 31.

It can be understood that the inner sidewall of the second connection structure is provided with a second connection structure for connecting with the main control board 31, and the second connection structure can be in the form of a buckle. The second connection structure can be arranged at an outer edge of the second installation groove 2241, and can be matched with a snap-fit hole on the main control board 31 to achieve snap-fit connection. The main control board 31 is the main circuit board of the controller, and it is arranged parallel to the upper cover 22 as a whole. The main control board 31 can be electrically connected to the power board 30 through pin docking. By forming the second installation groove 2241 between the upper cover 22 and the power supply rear cover 21 to accommodate the main control board 31, and fixing the second connection structure to the main control board 31, the overall appearance can be more coordinated and the installation and disassembly can be facilitated.

As shown in FIGS. 12 to 14, in some embodiments of the present utility model, the controller further includes an electronic paper display assembly 50, which is provided on one side of the upper cover 22 that faces away from the power supply rear cover 21.

It can be understood that a screen opening can be provided on the upper cover 22, and the part of the electronic paper display assembly 50 corresponds to the screen opening. The electronic paper display assembly 50 can be fixed to a front side of the upper cover 22 by adhesive, that is, the side of the upper cover 22 that faces away from the power supply rear cover 21. The shape of the electronic paper display assembly 50 can be adapted to the shape of one side of the upper cover 22 that faces away from the power supply rear cover 21. A display glass of the electronic paper display has a relatively thin thickness, and the electronic control part on a rear side of the display glass can be snap-fitted and fixed in the screen opening to enhance the reliability of connection. The electronic paper display assembly 50 and the main control board 31 can be electrically connected through a circuit. By providing the electronic paper display assembly 50, user interaction functions can be achieved, and the overall thickness of the controller can be reduced, improving aesthetics and making it easy to clean.

As shown in FIGS. 12 to 16, in some embodiments of the present utility model, the electronic paper display assembly 50 has a first installation hole 51, and the controller further includes a knob assembly 60 and a light guide assembly 70. Part of the light guide assembly 70 is provided in the first installation hole 51. The light guide assembly 70 has a second installation hole 72, and the upper cover 22 has a third installation hole 2242. Part of the knob assembly 60 is rotatably installed in the second installation hole 72 and the third installation hole 2242.

It can be understood that the knob assembly 60 is provided on the second shell for users to manually adjust. One end of the knob assembly 60 is inserted through a first knob hole and a second knob hole into the second shell, and is electrically connected to the main control board 31. The other end of the knob assembly 60 extends out of the second shell for facilitating user operation. A light guide column is sleeved on an outer side of the knob assembly 60 through its own second knob hole. The knob assembly 60 forms a limiting fit with a limiting platform on the second shell through a third buckle 61, so that the knob assembly 60 is limited in the axial direction, reducing the phenomenon of accidental detachment of the limiting assembly. The light guide assembly 70 may include a light guide column, which is connected and fixed to a snap-fit hole on the second shell through a fourth buckle 71. The light guide column can display the light emitted by a light display element on the main control board 31 to prompt the users and improve the aesthetic level.

As shown in FIGS. 8 to 10, in some embodiments of the present utility model, a depth of the installation groove is larger than a thickness of the installation hanging plate 10.

It can be understood that the depth of the installation groove refers to the thickness of the installation groove in a direction from a first end to a second end of the shell assembly, and the thickness of the installation hanging plate 10 also refers to the thickness of the installation hanging plate 10 in the direction from the first end to the second end of the shell assembly. The depth of the installation groove is larger than the thickness of the installation hanging plate 10, so that the installation hanging plate 10 can be fully embedded into the interior of the installation groove, and the installation hanging plate 10 will not protrude out of the installation groove. During installation, the installation hanging plate 10 does not protrude out of the installation groove, so that the thickness of the controller protruding out of the wall is the thickness of the shell assembly minus the thickness of the power supply rear cover 21 embedded in the wall, which is advantageous for reducing the overall thickness of the controller.

According to a second aspect of the present utility model, an electrical device is also proposed, which includes a control system and the controller in the technical solution of the first aspect. The controller is electrically connected to the control system, and can send control signals to the control system of the electrical device by operating the controller. The control system controls the operation of the electrical device based on the control signals. The electrical device includes but is not limited to an air conditioning device.

When the electrical device is an air conditioning system, the controller can be a thermostat. The controller of the electrical device proposed by the present utility model has the advantageous effects of small thickness protruding out of the wall or door, high aesthetics, and easy cleaning. The first installation groove 115 is provided between the two opposite ends of the shell assembly, and the installation hanging plate 10 is arranged inside the first installation groove 115. The installation hanging plate 10 is embedded in the first installation groove 115. During installation, the first end of the controller is embedded and installed in the wall or door, resulting in a smaller protruding thickness of the controller. The installation hanging plate 10 is fixedly connected to the wall or door, and the embedded arrangement of the installation hanging plate 10 ensures that the installation hanging plate 10 will not increase the overall thickness of the controller. The structure of partially embedding the controller into the wall or door makes the controller protrude by a small amount when installed on the wall or door, which is more beautiful, coordinated, and advantageous for cleaning.

Described above are only specific preferred embodiments of the present utility model, but the scope of protection of the present utility model is not limited to this. Any changes or replacements that can be easily conceived by those skilled in the art within the technical scope disclosed by the present utility model should be covered within the scope of protection of the present utility model. Therefore, the scope of protection of the present utility model should be accorded with the scope of protection of the claims.

## Claims

1. A controller, comprising:
an installation hanging plate, which comprises a hanging plate body and an ear plate, wherein the hanging plate body is provided with an opening, and the ear plate is provided on an inner edge of the hanging plate body and extends toward an interior of the opening; the ear plate is provided with a first connection portion, the hanging plate body is provided with a second connection portion, and the first connection portion and the second connection portion are selectively connected to pre-assembled members; and
a control module, which is partially inserted through the opening and connected to the installation hanging plate.

2. The controller according to claim 1, wherein the installation hanging plate is provided with a first error-proofing structure, and the control module is provided with a second error-proofing structure, which is adapted and connected to the first error-proofing structure.

3. The controller according to claim 1, wherein the first connection portion comprises an assembly hole provided on the ear plate, which is used to correspond with an installation hole of the pre-assembled member which is a junction box.

4. The controller according to claim 1, wherein the installation hanging plate is provided with indication signs.

5. The controller according to claim 2, wherein the first error-proofing structure comprises at least one ear plate arranged on the inner edge of the installation hanging plate, and the second error-proofing structure comprises at least one assembly groove arranged at one end of the control module that faces the installation hanging plate, the contour of each assembly groove matching the contour of a unique one ear plate.

6. The controller according to claim 5, wherein an inner edge of the opening abuts with an outer peripheral surface of the control module;
the opening comprises a first inner edge and a second inner edge arranged opposite to each other in a first direction, and the ear plate is located between the first inner edge and the second inner edge;
wherein a distance between the ear plate and the first inner edge is larger than a distance between the ear plate and the second inner edge, or the distance between the ear plate and the first inner edge is smaller than the distance between the ear plate and the second inner edge.

7. The controller according to claim 5, wherein the control module comprises a power supply rear cover, which comprises a rear casing portion and a convex edge portion that are connected to each other; the convex edge portion is provided on an outer peripheral surface of the rear casing portion and extends in a circumferential direction of the rear casing portion; the convex edge portion abuts with the installation hanging plate, and the rear casing portion is inserted into the opening;
wherein the rear casing portion is provided with the assembly groove that matches the contour of the ear plate, and when the control module is installed on the installation hanging plate, the ear plate is arranged in the assembly groove.

8. The controller according to claim 7, wherein the rear casing portion is provided with at least one buckle, and the power supply rear cover is snap-fitted to the installation hanging plate through the at least one buckle.

9. The controller according to claim 8, wherein the buckle comprises a cantilever portion suspended at one end and a protruding portion provided at a free end of the cantilever portion; the protruding portion is spaced apart from the convex edge portion, and the installation hanging plate is clamped between the protruding portion and the convex edge portion.

10. The controller according to claim 9, wherein in an insertion direction of the buckle, one end of the protruding portion that faces away from the convex edge portion is configured as a first guide surface inclined relative to the installation hanging plate;
and/or in the insertion direction of the buckle, one end of the protruding portion that faces the convex edge portion is configured as a second guide surface inclined relative to the installation hanging plate.

11. The controller according to claim 2, wherein an outer edge of the installation hanging plate is provided with a disassembly and assembly guide buckle, and a guide groove is provided on an end face of one side of the control module that faces the installation hanging plate; the disassembly and assembly guide buckle is inserted into the guide groove, and the guide groove forms a disassembly port at the edge of the control module.

12. The controller according to any one of claims 7 to 11, wherein the second connection portion comprises at least one connection hole provided on the hanging plate body, which is used for a connector to pass through, so that the installation hanging plate is connected with the pre-assembled member in the form of a frame.

13. The controller according to claim 12, wherein the convex edge portion is provided with multiple avoidance grooves, which are arranged in a one-to-one correspondence with the connection holes.

14. The controller according to claim 7, wherein the control module further comprises an upper cover connected to the power supply rear cover, and a first installation groove is provided on one side of the power supply rear cover that faces away from the upper cover; the installation hanging plate is at least partially accommodated in the first installation groove, and is connected to the power supply rear cover.

15. The controller according to claim 14, wherein the power supply rear cover is partially recessed on one side facing the upper cover to form a receiving groove, and
the control module further comprises a power board, which is arranged in the receiving groove.

16. The controller according to claim 15, wherein one of inner wall surfaces of the power board and the receiving groove is provided with a limiting protrusion, and the other is provided with a limiting groove, the limiting protrusion being inserted into the limiting groove;
and/or the inner wall surface of the receiving groove is provided with a first connection structure, which is connected to the power board.

17. The controller according to claim 14, wherein a second installation groove is provided on one side of the upper cover that faces the power supply rear cover, and the controller further comprises a main control board, which is arranged in the second installation groove and connected to the upper cover and/or the power supply rear cover;
and/or one of the convex edge portion and the upper cover is provided with a first snap-fit protrusion, the other is provided with a snap-fit groove, and the upper cover and the power supply rear cover are snap-fitted to the snap-fit groove through the first snap-fit protrusion.

18. The controller according to claim 17, wherein an inner sidewall of the second installation groove is provided with a second connection structure, which is connected to the main control board.

19. The controller according to claim 14, wherein the control module further comprises an electronic paper display assembly, which is arranged on one side of the upper cover that faces away from the power supply rear cover.

20. The controller according to claim 19, wherein the electronic paper display assembly has a first installation hole, the control module further comprises a knob assembly and a light guide assembly, and part of the light guide assembly is provided in the first installation hole; the light guide assembly has a second installation hole, the upper cover has a third installation hole, and part of the knob assembly is rotatably installed in the second installation hole and the third installation hole.

21. An electrical device, wherein the electrical device comprises a control system and the controller according to any one of claims 1 to 20, and the controller is electrically connected to the control system.
